Europäisches Patentamt

(19) European Patent Office

Office européen des brevets

(11) Numéro de publication: **0 252 538**
**A1**

(12) **DEMANDE DE BREVET EUROPEEN**

(21) Numéro de dépôt: **87200979.0**

(22) Date de dépôt: **27.05.87**

(51) Int. Cl.4: **G01R 19/165** , G01R 19/00 , G01R 1/067 , H03F 1/56

(30) Priorité: **06.06.86 FR 8608185**

(43) Date de publication de la demande: **13.01.88 Bulletin 88/02**

(84) Etats contractants désignés: **DE FR GB**

(71) Demandeur: **Laboratoires d'Electronique et de Physique Appliquée L.E.P. 3, Avenue Descartes F-94450 Limeil-Brévannes(FR)**

(84) **FR**

(71) Demandeur: **N.V. Philips' Gloeilampenfabrieken Groenewoudseweg 1 NL-5621 BA Eindhoven(NL)**

(84) **DE GB**

(72) Inventeur: **Boutigny, Pierre-Henri Société Civile S.P.I.D. 209, rue de l'Université F-75007 Paris(FR)**

(74) Mandataire: **Landousy, Christian et al Société Civile S.P.I.D. 209, Rue de l'Université F-75007 Paris(FR)**

(54) **Circuit d'entrée pour sonde d'analyseur logique, et sonde et analyseur logique munis d'un tel circuit.**

(57) Circuit d'entrée (7) pour sonde d'analyseur logique pour l'analyse de signaux logiques rapides, superposés ou non à une composante continue, adapté à des types de logiques différents. Il comprend pour chaque voie, une capacité d'entrée (20) suivi d'un amplificateur haute fréquence (22) et d'un circuit de compensation (24) qui compare l'écart entre les composantes continue et basse fréquence apparaissant sur les bornes d'entrée (2) et de sortie (4), puis qui compense cet écart en réinjectant un signal sur l'entrée de l'amplificateur haute fréquence (22). Ce circuit (7) peut comprendre en outre un atténuateur variable (30, 31) qui peut être commandé à distance.

FIG.3

## CIRCUIT D'ENTREE POUR SONDE D'ANALYSEUR LOGIQUE, ET SONDE ET ANALYSEUR LOGIOUE MUNIS D'UN TEL CIRCUIT

L'invention concerne un circuit d'entrée pour sonde d'analyseur logique pour la transmission aux fréquences élevées d'un signal logique, comportant, entre une borne d'entrée et une borne de sortie, un amplificateur haute fréquence à haute impédance d'entrée de gain inférieur à l'unité, qui délivre un signal de sortie sous une basse impédance, disposée entre la borne de sortie et la masse.

Elle concerne également une sonde logique et un analyseur logique équipés d'un tel circuit d'entrée.

Un circuit de ce genre est connu du document US 4 498 058 qui décrit un amplificateur à faible capacité d'entrée destiné à réaliser une sonde pour oscilloscope. Cette sonde a pour but d'analyser des signaux électriques ayant des temps de montée de l'ordre de la nanoseconde avec une dynamique en tension de ± 10 volts sur une impédance de charge de 50 ohms. Afin de disposer d'une impédance d'entrée élevée (5 Megohms) et d'une capacité d'entrée faible (0,5 pF), le transistor d'entrée est un transistor à effet de champ.

Un tel circuit d'entrée peut schématiquement se décomposer en un amplificateur haute fréquence à haute impédance d'entrée, suivi d'un atténuateur fixe et d'une liaison coaxiale basse impédance 50 ohms. Un tel circuit présente un coefficient d'atténuation fixe ce qui est mal adapté pour analyser des signaux logiques standardisés dont les dynamiques sont très différentes, par exemple 5 volts pour une logique TTL ou 0,8 volt pour une logique ECL. D'autre part, ces signaux logiques, en particulier les signaux ECL, possèdent une composante continue, et dans le cas du circuit d'entrée de l'art antérieur une telle composante continue (et également basse fréquence) est transmise par un tel circuit. La détec tion de signaux logiques de faible amplitude superposés à une composante continue parfois plus élevée peut entraîner des difficultés de détection, ce qui est générateur d'erreurs. Ceci est aggravé par le fait que ces composantes continue et basse fréquence ne sont pas stables et sont sujettes à variations, notamment avec la température.

Un but de l'invention est donc de proposer un circuit d'entrée permettant de transmettre vers un analyseur logique des signaux ayant des temps de montée et de descente rapides, et qui puisse être réglé ou programmé pour des dynamiques d'amplitudes variées.

Un autre but de l'invention est de pouvoir s'affranchir de la composante continue du signal logique afin d'accroître la précision de détection des signaux logiques superposés à une composante continue.

Un autre but est, pour une dynamique donnée, de pouvoir déterminer avec précision des seuils de détection situés dans l'excursion totale afin d'en déduire des indications sur les temps de montée et de descente des signaux logiques.

Pour cela l'invention telle que définie dans le préambule est remarquable en ce que le circuit d'entrée comprend une capacité disposée entre la borne d'entrée du circuit et l'entrée de l'amplificateur, et en parallèle entre les bornes d'entrée et de sortie, un circuit de compensation comparant l'écart entre les composantes continue et basse fréquence des signaux respectifs apparaissant sur ces deux bornes, et délivrant un signal de compensation, destiné à compenser cet écart, sur la borne d'entrée de l'amplificateur à l'aide d'un élément d'injection, le circuit de compensation possédant une entrée contrôlée par un signal continue de décalage déterminé afin de compenser la composante continue.

Une analyse précise des signaux logiques d'entrée peut seulement être réalisée avec des circuits à haute impédance d'entrée, de sorte que la capacité d'entrée doit être de très faible valeur. Cette valeur est de l'ordre de 1 pF afin d'assurer la précision requise aux environs de 1 GHz qui représente la limite maximale des signaux logiques à analyser. Pour ces fréquences, l'échantillonnage s'effectue vers 2 GHz.

Afin de déterminer les temps de montée et de descente des signaux d'entrée, la conversion A/N s'effectue sur 2 bits. Ceci peut être réalisé à l'aide de comparateurs GaAs.

Un circuit d'entrée ayant une bande passante de 1 GHz présente des temps de montée égaux ou inférieurs à environ 300 ps, ce qui peut poser des problèmes de délai de transmission dans les câbles de liaison. Pour cela l'invention utilise par signal une liaison analogique à câble unique qui permet de s'affranchir des dispersions de propagation dans des câbles multiples. La conversion A/N est alors effectuée dans l'analyseur logique lui-même.

Ceci à également pour avantage de réduire la taille de la sonde en réduisant le nombre de câbles de liaisons.

·La capacité placée à l'entrée de chaque amplificateur haute fréquence laisse passer la composante haute fréquence du signal d'entrée (maximum environ 1 GHz). Le circuit de compensation prélève directement sur la borne d'entrée les composantes continue et basse fréquence du signal d'entrée. De la même façon le circuit de compensation est réuni à la borne de sortie et prélève également les composantes continue et basse fréquence des signaux sur la borne de sortie. Le circuit de compensation compare ces deux types de composantes et génère un signal de compensation qui est introduit sur la borne d'entrée de l'amplificateur haute fréquence afin de faire que l'écart entre ces deux types de composantes soit le plus faible possible. Le circuit de compensation possède également une entrée sur laquelle on peut appliquer un signal continue de décalage destiné à compenser la composante continue du signal logique à analyser.

On dispose ainsi d'une boucle de contre-réaction constituée de l'amplificateur haute fréquence et du circuit de compensation via sa sortie de compensation et une de ses entrées.

Cette boucle d'asservissement surveille la stabilité et contrôle toutes les variations, les non-linéarités et la stabilisation de l'amplificateur HF. La stabilisation en continu est de l'ordre de 1 mV.

L'invention a également pour but de permettre l'analyse de signaux logiques ayant des dynamiques différentes. Pour cela à la sortie de l'amplificateur haute fréquence on dispose d'un atténuateur qui peut être réglé par un signal de contrôle d'atténuation d'une manière programmable. Cet atténuatuer est constitué par un transistor à effet de champ (TEC) placé en parallèle avec une résistance entre la sortie de l'amplificateur et la borne de sortie. La grille de ce TEC, par exemple en GaAs, est contrôlée par le signal de contrôle d'atténuation qui agit simultanément sur le circuit de compensation afin que la compensation effectuée soit atténuée dans les mêmes proportions. Ainsi un signal logique d'entrée de 5 volts de dynamique pourra être atténué à 0,5 volt, ce qui permet de diminuer sérieusement le courant de sortie dans l'impédance 50 ohms délivré par un montage "émetteur-suiveur".

Ce circuit d'entrée est réuni par une liaison coaxiale 50 ohms à des comparateurs, par exemple situés dans l'analyseur logique lui-même, afin d'effectuer la conversion analogique-numérique. Grâce à ce circuit d'entrée, les comparateurs peuvent être calés avec une grande précision sur des seuils déterminés. Ceci permet tout d'abord d'assurer une très grande fiabilité de détection à l'analyseur logique et ensuite de permettre de détecter les instants de basculement pour des seuils par exemple situés à 20%, 50% et 80% de l'excursion maximale, et de déterminer ainsi les temps de montée et de descente des signaux logiques à l'aide d'une seule liaison.

Le circuit de compensation qui traite les composantes continue et basse fréquence est constitué d'amplificateurs opérationnels.

Le circuit d'entrée est utilisé pour réaliser une sonde. Celle-ci comprend une partie mobile de très faibles dimensions formée de la capacité, de l'amplificateur haute fréquence et de l'élément d'injection. Elle peut également comprendre l'étage d'atténuation variable. Cette partie mobile est reliée par des liaisons coaxiales 50 ohms à la partie fixe de la sonde qui peut soit être placée dans l'analyseur logique soit constituer un boîtier encastrable sur l'analyseur logique.

Cette sonde transmet les signaux sous une forme analogique, la conversion A/N étant effectuée dans l'analyseur lui-même sur 1 ou 2 bits. Ceci permet de diminuer l'encombrement de la sonde et réduit considérablement le nombre de fils de liaison par rapport à une réalisation effectuant la conversion A/N à l'endroit du prélèvement du signal. C'est un circuit d'entrée dont la conception est adaptée au problème des analyseurs logiques avec des performances multiples et une réalisation simplifiée par rapport à l'art antérieur. La sonde logique présente pour cela un coût réduit.

L'invention sera mieux comprise à l'aide des figures suivantes, données à titre d'exemples non limitatifs, qui représentent :

figure 1 : une représentation schématique d'un circuit d'entrée selon l'art antérieur,

figure 2 : un schéma électrique d'un circuit d'entrée selon l'invention,

figure 3 : un schéma électrique d'un circuit d'entrée analogue à celui de la figure 2 avec en outre une programmation de l'atténuation,

figure 4 : un schéma électrique analogue à celui de la figure 3 avec une représentation plus détaillée du circuit de compensation,

figure 5 : un schéma électrique d'une sonde logique comprenant un tel circuit réunie aux comparateurs de l'analyseur logique.

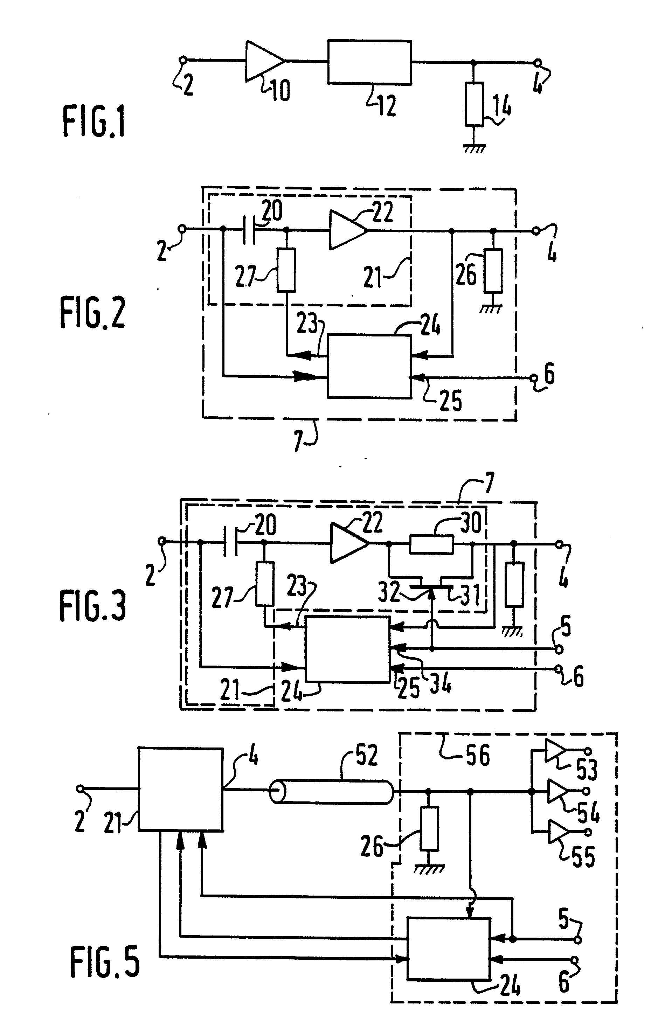

La figure 1 représente un schéma d'un circuit d'entrée selon l'art antérieur US 4 498 058. Un amplificateur haute fréquence à haute impédance d'entrée 10 est disposé en série avec un atténuateur fixe 12 entre une borne d'entrée 2 et une borne de sortie 4. Celle-ci est réunie à la masse par une résistance 14 de faible valeur généralement 50 ohms. Le gain total d'un tel circuit d'entrée est fixe et, par exemple, avec un gain de 0,1, on dispose en sortie d'un signal de 0,5 volt pour des signaux TTL et 0,08 volt pour des signaux ECL. Mais les composantes continues et basse fréquences passent dans ce circuit d'entrée, et aucune correction de décalage n'est possible pour supprimer la composante continue qui d'ailleurs peut varier avec, par exemple, la température. La détermination de seuils précis n'est pas directement réalisable avec un tel circuit, ce qui ne permet pas de déterminer des temps de montée et de descente après conversion A/N.

La figure 2 représente un schéma électrique d'un circuit d'entrée 7 selon l'invention. Entre les bornes d'entrée 2 et de sortie 4 sont placés en série une capacité 20 et un amplificateur HF 22. Un circuit de compensation 24 des composantes continues et basse fréquences (BF) prélève les signaux continu et BF présents sur les bornes d'entrée 2 et de sortie 4. Le circuit 24 génère un signal de compensation sur la sortie 23 afin que l'écart entre les signaux des deux bornes tende à s'annuler. Ce signal de compensation est introduit, à travers un élément d'injection 27, sur l'entrée de l'amplificateur HF. Le circuit de compensation 24 reçoit, sur une entrée 25, un signal continu de décalage, issu d'une borne 6, que l'on détermine afin de compenser la composante continue contenue dans le signal d'entrée. La borne de sortie 4 est reliée à une résistance de faible impédance 26 par exemple 50 Ohms. La partie mobile 21 de la sonde comprend la capacité 20, l'amplificateur 22 et l'élément 27.

La figure 3 représente un schéma électrique d'un circuit d'entrée analogue à celui de la figure 2, avec les mêmes éléments munis des mêmes repères, mais qui comprend un atténuateur qui permet de limiter la dynamique de sortie, de la programmer ou de l'adapter aux signaux à analyser et de limiter ainsi le courant délivré par l'amplificateur HF.

Pour cela, entre la sortie de l'amplificateur 22 et la borne de sortie 4, on place en parallèle une résistance 30 et un transistor à effet de champ 31. La grille 32 de ce transistor est contrôlée et le transistor est rendu passant ou non par un signal d'atténuation issu d'une borne 5, qui arrive également sur une borne 34 du circuit de compensation 24. Il est ainsi possible d'atténuer simultanément la voie HF et la voie BF et continu.

La partie mobile 21 de la sonde comprend, outre les éléments précédents, l'étage d'atténuation variable.

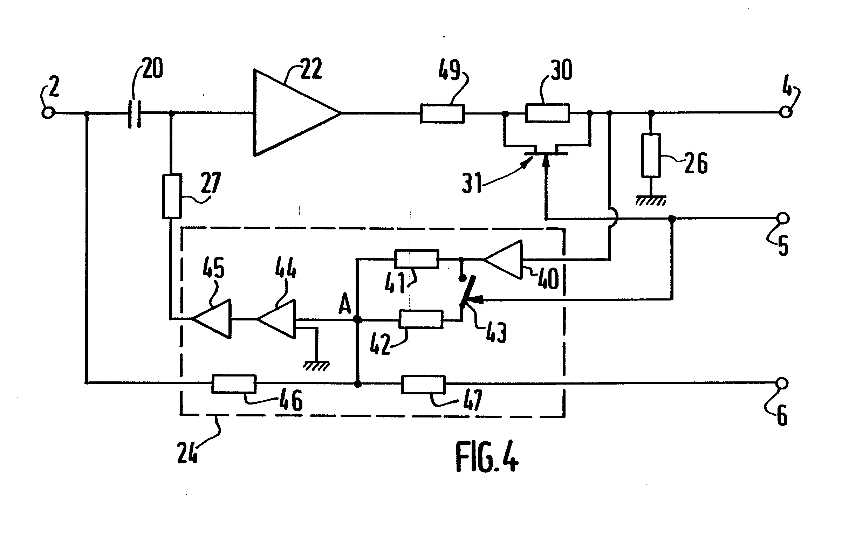

La figure 4 indique avec plus de détails le schéma électrique du circuit de compensation 24. Un amplificateur inverseur 40 de gain -1 est relié à la sortie de l'atténuateur 30, 31 et au point commun d'une résistance 41 et d'un interrupteur 43. L'autre borne de l'interrupteur 43 est relié à une résistance 42 elle-même reliée à la résistance 41 au point A. Ainsi selon la position de l'interrupteur la résistance équivalente est égale à la résistance 41 de valeur élevée, par exemple 5 Kohms, ou à la valeur de la résistance 41 en parallèle avec la résistance 42 de valeur plus faible par exemple 1 Kohm.

Le point A est réuni à une entrée d'un amplificateur opérationnel 44 dont l'autre entrée est réunie à la masse. La sortie de l'amplificateur 44 est reliée à l'entrée d'un amplificateur inverseur 45 qui injecte le signal de compensation, à travers l'élément 27, sur l'entrée de l'amplificateur HF 22. Cet élément 27 peut être une résistance mais préférentiellement on utilise un transistor afin d'effecteur la compensation en courant. Le circuit de compensation 24 prélève le signal d'entrée à l'aide d'une résistance 46 de valeur R. De même le signal de décalage en provenance de la borne 6, est appliqué au point A à travers une résistance 47.

La boucle de contre-réaction pour les composantes continue et basse fréquence effectue la réinsertion du signal sur la borne d'entrée de l'amplificateur haute fréquence c'est-à-dire après la capacité d'entrée. La dynamique nécessaire à la compensation est ainsi égale à la dynamique du signal d'entrée. La partie réelle de l'impédance d'entrée de la boucle varie de la valeur R aux basses fréquences, à la valeur R en parallèle sur $Z_c$, si $Z_c$ est la partie résistive de l'impédance d'entrée de l'amplificateur HF 22.

En appelant :
$Z_p$ : l'impédance d'entrée de la sonde, mesurée au point 2,
$Z_e$ : l'impédance d'entrée de l'amplificateur HF,
$Z_s$ : l'impédance de sortie de la source de signaux logiques,
R : valeur de la résistance 46.
G étant le gain obtenu entre les signaux en sortie 4 et en entrée 2, on obtient les variations de gain DG du gain G entre la basse fréquence et la haute fréquence par :

$$\frac{DG}{G} = \frac{DZ_p}{Z_p}\left(1 - \frac{Z_p}{Z_s + Z_p}\right)$$

Les variations d'impédance d'entrée de sonde étant :

$$\frac{DZ_p}{Z_p} = \frac{R}{R + Z_e}$$

on obtient pour les variations du gain en fonction de l'impédance de source :

$$\frac{DG}{G} = \frac{R}{Z_e}\left(1 - \frac{R}{Z_s + R}\right).$$

Ces variations relatives sont les mêmes quel que soit l'état de l'atténuateur constitué par le transistor 31 et la résistance 30.

Selon un exemple préférentiel, avec R = 10 Kohms, Zs = 1 Kohm et Ze supérieur à 100 Kohms, la variation maximale de gain est de 1%.

L'amplificateur HF est de conception classique avec un étage de sortie disposant de deux transistors en collecteurs communs pour débiter dans une impédance de charge de 100 ohms (2x50 ohms). La fréquence de coupure basse de l'amplificateur est d'environ 200 Hz pour éviter des problèmes de stabilité dus à la bande passante limitée de la boucle de contre réaction continue et basse fréquence. Une résistance 49 de valeur égale à la résistance 26, par exemple 50 ohms, est placée à la sortie de l'amplificateur HF 22 afin de constituer l'impédance de charge de 100 ohms lorsque le transistor à effet de champ 31 est passant. Sa résistance est alors inférieure à environ 6 ohms et ses éléments parasites très faibles. La résistance 30 vaut dans ce cas, par exemple, 400 ohms. Ainsi avec un signal TTL de 5 volts de dynamique et une atténuation de 10 on obtient en sortie une dynamique de 0,5 volt. De même avec un signal ECL de 1 volt de dynamique et une atténuation de 2 on obtient en sortie une dynamique de 0,5 volt.

La figure 5 représente un schéma électrique d'une sonde logique comportant plusieurs circuits d'entrée selon l'invention, un seul étant représenté sur la figure. La partie mobile 21 de la sonde présente sur sa sortie 4 un signal qui est transmis à travers une ligne coaxiale 50 ohms 52, constituée d'un câble réuni à la partie fixe 56 fixée à l'analyseur logique. La résistance de charge 26 est préférentiellement disposée après la liaison 50 ohms. La partie fixe comprend des comparateurs dont le nombre dépend de la précision de conversion souhaitée.

Ces comparateurs, par exemple au GaAs au nombre de trois, 53, 54, 55, sont chacun calés sur un seuil déterminé par exemple à 20%, 50% et 80% de l'excursion maximale. L'utilisation du comparateur réglé sur 50% permet d'effectuer une conversion A/N à 1 bit. L'utilisation des comparateurs réglés sur 20% et 80% permet d'effectuer une conversion A/N sur 2 bits et d'en déduire les temps de montée et de descente du signal à partir d'un traitement effectué dans l'analyseur logique.

Le schéma de la figure 5 est utilisé pour chaque signal logique d'entrée à traiter. Par exemple dans le cas où il y a 8 signaux à traiter, on place 8 circuits d'entrée 7 dans une sonde avec 8 liaisons pour les signaux de sortie, plus une liaison pour le prélèvement du signal d'entrée, une liaison pour l'atténuation et une liaison pour la tension de décalage. Il faut bien sûr ajouter à ceci les tensions d'alimentation des amplificateurs. Une telle sonde est réunie à un analyseur logique qui effectue l'interprétation des signaux analysés.

## Revendications

1. Circuit d'entrée pour sonde d'analyseur logique pour la transmission aux fréquences élevées d'un signal logique, comportant, entre une borne d'entrée et une borne de sortie, un amplificateur haute fréquence à haute impédance d'entrée de gain inférieur à l'unité, qui délivre un signal de sortie sous une basse impédance, disposée entre la borne de sortie et la masse, caractérisé en ce que le circuit d'entrée comprend une capacité disposée entre la borne d'entrée du circuit et l'entrée de l'amplificateur, et en parallèle entre les bornes d'entrée et de sortie, un circuit de compensation comparant l'écart entre les composantes continue et basse fréquence des signaux respectifs apparaissant sur ces deux bornes, et délivrant un signal de compensation, destiné à compenser cet écart, sur la borne d'entrée de l'amplificateur à l'aide d'un élément d'injection, le circuit de compensation possédant une entrée contrôlée par un signal continu de décalage déterminé afin de compenser la composante continue.

2. Circuit d'entrée selon la revendication 1, caractérisé en ce qu'il comprend, entre la sortie de l'amplificateur et la borne de sortie, un étage d'atténuation variable formé d'une résistance série en parallèle avec un transistor à effet de champ dont le potentiel de grille est contrôlé par un signal d'atténuation qui contrôle également le circuit de compensation afin de disposer de la même atténuation sur la voie HF et sur la voie BF/continu.

3. Circuit d'entrée selon la revendication 2, caractérisé en ce que le transistor à effet de champ est en arséniure de gallium.

4. Sonde pour analyseur logique caractérisée en ce qu'elle comprend au moins un circuit d'entrée selon la revendication 1, le circuit d'entrée étant décomposé en une partie mobile formée de la capacité, de l'amplificateur haute fréquence et de l'élément d'injection, la partie mobile étant reliée par des liaisons coaxiales à une partie fixe, qui com prend le circuit de compensation, solidaire de l'analyseur logique.

5. Sonde pour analyseur logique caractérisée en ce qu'elle comprend au moins un circuit d'entrée selon une des revendications 2 ou 3, le circuit d'entrée étant décomposé en une partie mobile formée de la capacité, de l'amplificateur haute fréquence, de l'élément d'injection et de l'étage d'atténuation variable, la partie mobile étant reliée par des liaisons coaxiales à une partie fixe, qui comprend le circuit de compensation, solidaire de l'analyseur logique.

6. Sonde selon les revendications 4 ou 5, caractérisée en ce que chaque circuit d'entrée comprend au moins un comparateur, placé dans la partie fixe qui détecte un niveau déterminé et délivre un signal de comparaison.

7. Sonde selon la revendication 6, caractérisée en ce que au moins une des sorties du circuit d'entrée est réunie à plusieurs comparateurs afin de déterminer les temps de montée et de descente du signal logique.

8. Sonde selon la revendication 6, caractérisée en ce qu'il y a trois comparateurs, les niveaux déterminés respectifs étant sensiblement 20%, 50% et 80% de l'excursion maximale afin de déterminer les temps de montée et de descente des signaux logiques.

9. Sonde selon les revendications 4 à 8, caractérisée en ce que les comparateurs sont en arséniure de gallium.

10. Analyseur logique caractérisé en ce qu'il comporte au moins une sonde selon une des revendications 4 à 9.

FIG.1

FIG.2

FIG.3

FIG.5

FIG.4

2-II-PHF86-550

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl 4) |
|---|---|---|---|
| Y | US-A-3 441 863  (MORIYASU) <br> * Abrégé;  colonne 2, ligne 53 - colonne 4, ligne 8; figure 1 * | 1 | G 01 R  19/165 <br> G 01 R  19/00 <br> G 01 R  1/067 <br> H 03 F  1/56 |
| | --- | | |
| Y | FR-A-2 434 538  (THOMSON CSF) <br> * Page 2, lignes  8-23;  page  6, lignes 5-31; figure 5 * | 1 | |
| | --- | | |
| Y | HEWLETT-PACKARD JOURNAL, vol. 21, no. 4, décembre 1969, pages 12-16, Palo Alto, US; J. ZELLMER: "High impedance probing to 500 MHz" <br> * Page  12;  page 16, colonne 1, lignes 1-15; figure 2 * | 1 | |
| | --- | | |
| A | IDEM | 4-6,10 | DOMAINES TECHNIQUES RECHERCHES (Int. Cl.4) |
| | --- | | |
| A | DE-A-3 432 091  (HAHN-MEITNER INST.) <br> * Page 10, ligne  7  - page  14, ligne 34; figures 1,2 * | 1 | G 01 R  19/00 <br> G 01 R  1/00 <br> G 01 R  17/00 <br> G 01 R  13/00 <br> H 03 F  1/00 |
| | --- | | |
| A | FR-A-2 167 404  (CIT-ALCATEL) <br> * Page 2, ligne 8 - page 3, ligne 38;  page 4, lignes 9-20; figures 2,4 * | 1 | |
| | --- | | |
| A | GB-A-2 108 797  (AKG GmbH) <br> * Abrégé; figure 3 * | 1 | |
| | ---       -/- | | |

Le présent rapport de recherche a été établi pour toutes les revendications

| Lieu de la recherche | Date d'achèvement de la recherche | Examinateur |
|---|---|---|
| LA HAYE | 06-10-1987 | ALLEN E.F. |

| | DOCUMENTS CONSIDERES COMME PERTINENTS | | Page 2 |
|---|---|---|---|
| **Catégorie** | **Citation du document avec indication, en cas de besoin, des parties pertinentes** | **Revendication concernée** | **CLASSEMENT DE LA DEMANDE (Int Cl 4)** |
| A | TECHNICAL DIGEST, no. 45, janvier 1977, pages 27-29, Western Electric, New York, US; H.L. MADDOX: "High input impedance capacitance coupled voltage probes" * Page 27, lignes 1-10; page 28, dernier paragraphe - page 29, la fin; figure 2 * | 1 | |
| A | US-A-3 995 175 (HOYT et al.) * Colonne 1, ligne 51 - colonne 2, ligne 40; figures 1-2 * | 1,7,10 | |
| A | TOUTE L'ELECTRONIQUE, no. 423, juillet 1977, pages 53-59, Paris, FR; R.-CH. HOUZE: "L'oscilloscope S61 telequipment" * Page 54, colonne 3, ligne 19 - page 55, colonne 1, ligne 20; figure 2a * | 2 | **DOMAINES TECHNIQUES RECHERCHES (Int. Cl.4)** |
| A | US-A-4 110 687 (SNEED, Jr.) * Colonne 1, ligne 51 - colonne 2, ligne 43; figures 1,4 * | 7 | |
| | --- -/- | | |

Le présent rapport de recherche a été établi pour toutes les revendications

| Lieu de la recherche | Date d'achèvement de la recherche | Examinateur |
|---|---|---|
| LA HAYE | 06-10-1987 | ALLEN E.F. |

## DOCUMENTS CONSIDERES COMME PERTINENTS

Page  3

| Catégorie | Citation du document avec indication, en cas de besoin, des parties pertinentes | Revendication concernée | CLASSEMENT DE LA DEMANDE (Int. Cl 4) |
|---|---|---|---|
| A | ELECTRONICS, vol. 51, no. 6, 16 mars 1978, pages 39-40, New York, US; "Single-chip level detector sells for 65c" <br> * Page 39, colonne 1, dernier paragraphe - page 40, colonne 2, la fin; figure * <br><br> --- | 8 | |
| A,D | US-A-4 498 058 (BENRUD) <br> * Colonne 1, ligne 49 - colonne 2, ligne 33; figure 1 * <br><br> ----- | 1 | |

DOMAINES TECHNIQUES RECHERCHES (Int. Cl.4)

Le présent rapport de recherche a été établi pour toutes les revendications

| Lieu de la recherche | Date d'achèvement de la recherche | Examinateur |
|---|---|---|
| LA HAYE | 06-10-1987 | ALLEN E.F. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82